(19)

Europäisches Patentamt
European Patent Office
Office européen des brevets

(11)  **EP 4 002 094 B1**

(12)  **EUROPEAN PATENT SPECIFICATION**

(45) Date of publication and mention
of the grant of the patent:
**12.02.2025  Bulletin 2025/07**

(21) Application number: **20208974.4**

(22) Date of filing: **20.11.2020**

(51) International Patent Classification (IPC):
**G06F 7/523** (2006.01)  **H03M 1/66** (2006.01)

(52) Cooperative Patent Classification (CPC):
**G06F 7/523;** G06F 2207/4814; H03M 1/765;
H03M 1/785

(54)  **COMPUTING ELEMENT FOR IN-MEMORY COMPUTING**

RECHENELEMENT FÜR SPEICHERINTERNE BERECHNUNG

ÉLÉMENT DE CALCUL EN MÉMOIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**25.05.2022  Bulletin 2022/21**

(73) Proprietor: **Nokia Technologies Oy
02610 Espoo (FI)**

(72) Inventor: **Kaltiokallio, Kim
00340 Helsinki (FI)**

(74) Representative: **Whiting, Gary
Venner Shipley LLP
5 Stirling House
Stirling Road
The Surrey Research Park
Guildford GU2 7RF (GB)**

(56) References cited:
**US-A1- 2019 057 303  US-B2- 7 160 577**

• P RAMAKRISHNA ET AL: "International Journal
of Engineering & Technology Design of low
power 10GS/s 6-Bit DAC using CMOS
technology", INTERNATIONAL JOURNAL OF
ENGINEERING & TECHNOLOGY, 1 January 2018
(2018-01-01), pages 226 - 229, XP055644881,
Retrieved from the Internet <URL:https://pdfs.
semanticscholar.
org/1fff/3bbefb6d12701d8d
b9a1e773a4c7d94bd8f7.pdf>

• ANONYMOUS: "INVERTED OR CURRENT AND
VOLTAGE MODE DAC", 6 June 2020
(2020-06-06), pages 1 - 3, XP055799074,
Retrieved from the Internet <URL:https://web.
archive.org/web/20200606133958if_/http://www.
idc-online.
com/technical_references/pdfs/electronic_engi
neering/Inverted_Or_Current_And_Voltage_Mo
de_Dac.pdf> [retrieved on 20210427]

• ANONYMOUS: "Digital to Analog Converters", 22
December 2018 (2018-12-22), XP055799069,
Retrieved from the Internet <URL:https://web.
archive.
org/web/20181222171349if_/http://eeedrmcet.
zohosites.com:80/files/III%20Year/SEM%
205/LIC/LIC_L33.PDF> [retrieved on 20210427]

• YUAN GUANGJIE ET AL: "A brief overview of
atomic layer deposition and etching in the
semiconductor processing", 2016 17TH
INTERNATIONAL CONFERENCE ON
ELECTRONIC PACKAGING TECHNOLOGY
(ICEPT), IEEE, 16 August 2016 (2016-08-16),
pages 1365 - 1368, XP032974479, DOI: 10.1109/
ICEPT.2016.7583377

EP 4 002 094 B1

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

**Description**

## TECHNOLOGICAL FIELD

Example embodiments relate to In-Memory Computing (IMC) and computing elements useful for In-Memory Computing.

## BACKGROUND

Integrated Circuits (ICs) are widespread in modern electronics and may be used to implement a wide range of processing and memory devices. In-memory computing technology is a developing area which aims to provide improvements in computational performance. Traditional systems tend to store data as electrical charges on a memory that is separate from the processor which performs tasks such as arithmetic and logic functions. With the increase in data required for certain applications, such as with neural network processing, data movement between the processor and memory may present one of the more critical performance and energy bottlenecks. In-memory computing can improve processing performance through the use of memory technologies that are also able to perform certain computational tasks such as the arithmetic and/or logical functions.

The article "Design of low power 10GS/s 6-Bit DAC using CMOS technology" by P Ramakrishna et. al. (International Journal of Engineering and Technology, 1 January 2018, pages 226-229) describes a low power 6-bit R-2R ladder Digital to Analog converter. The R-2R network uses only two values (R and 2xR) and a switch designed using both NMOS and PMOS transistors.

## BRIEF SUMMARY

The scope of protection sought for various embodiments of the invention is set out by the independent claims. The embodiments and features, if any, described in this specification that do not fall under the scope of the independent claims are to be interpreted as examples useful for understanding various embodiments of the invention.

According to an example embodiment, there is provided an apparatus that includes a resistive network with a plurality of basic computing elements coupled in series. Each basic computing element includes a first resistor having a first resistance value and a second resistor having a second resistance value. The first resistor couples an input voltage to an output voltage to be provided to a next basic computing element of the plurality of basic computing elements. The second resistor of the resistive network is coupled to an input of a memory switch that routes current received through the second resistor to either a summation bus or a subtraction bus. The apparatus also includes a signal processing unit coupled to the summation bus and the subtraction bus.

The first resistor and second resistor are configured as a current or voltage divider.

The first resistor and the second resistor include one or more high-resistance contacts formed by atomic layer deposition (ALD) of material sandwiched between conductive layers. In some examples, the high-resistance contacts have substantially a same resistance value, the second resistor comprises a single one of the high-resistance contacts, and the first resistor comprises two or more of the high-resistance contacts connected in parallel.

The second resistance value may be substantially twice that of the first resistance value.

The memory switch includes a first via switch coupled to the summation bus and a second via switch coupled to the subtraction bus.

The memory switch may be a first atom switch coupled to the summation bus and a second atom switch coupled to the subtraction bus.

According to another example embodiment, there may be provided a computing element that includes: a first resistor having a first resistance value and coupled in series between an input voltage and an output voltage; a second resistor having a second resistance value and coupled at an input of the first resistor to form a voltage or current divider; and a memory switch coupled at the output of the second resistor and configurable to route current received from the input through the second resistor to either a summation bus or a subtraction bus.

The memory switch is a first via switch coupled to the summation bus and a second via switch coupled to the subtraction bus.

The computing element may be used in an application that includes one or more of: a vector matrix multiplier application configured to beamform electromagnetic waves; a media processing application configured to compress media, wherein the media comprises one or more of video or audio; and a machine learning application.

## BRIEF DESCRIPTION OF THE DRAWINGS

Example embodiments will now be described, by way of non-limiting example, with reference to the accompanying drawings, in which.

Fig. 1 is a block diagram of a basic computing element in accordance with embodiments ;
Fig. 2 is a resistance ladder network that includes a set of basic computing elements, in accordance with embodiments;
Fig. 3 is an example of a basic computing element that uses a via switch, in accordance with embodiments;
Fig. 4 is a circuit diagram of an example via switch in accordance with embodiments;
Fig. 5 is a cross-sectional view of part of an integrated circuit that includes a memory switch;

Fig. 6 is a cross sectional view of two layers of an IC implementing a resistor ladder 600;

Fig. 7 is a cross-sectional view of a three-dimensional IC implementation 700 according to example embodiments;

Fig. 8 is a basic computing element with Field Effect Transistors (FETs);

Fig. 9 is a basic computing element with an atom switch;

Fig. 10 is a circuit diagram of an integrated circuit with another type of basic computing element 1002 in accordance with embodiments;

Fig. 11 is a circuit diagram of another integrated circuit with another type of basic computing element 1102 in accordance with embodiments; and

Fig. 12 is a block diagram showing a medium 1000 that contains logic for controlling an in-memory computing device.

## DETAILED DESCRIPTION

Example embodiments relate to integrated circuits (ICs) and integrated circuit fabrication techniques applicable to In-Memory Computing (IMC), also sometimes referred to as Computing-in-Memory (CIM) or Processing-in-Memory (PIM). More specifically, the present disclosure describes a basic computing element (BCE) that includes a resistor network and a memory switch that provides a routing function as well as a memory function. In some example embodiments, several basic computing elements can be linked together to form a resistor ladder network. As such, each basic computing element includes a pair of resistors that implement a current division between adjacent basic computing elements of the resistor ladder network. Each basic computing element also includes a memory switch that determines whether current passing through the basic computing element from the resistor ladder network is provided to a summation or subtraction output. The combined output of a series of such basic computing elements is an analog voltage that corresponds with a digital numerical value. In this way, multiplication and other arithmetic functions may be performed in the analog domain.

The programming of each basic computing element is determined using binary control bits that determine the state of the memory switch. The memory switch is a non-volatile memory switch, meaning that the state of the switch persists after the input signals provided by the control bits are removed. Thus, in a ladder network with multiple such basic computing elements connected in series, the values of the binary control bits used to set the switch state determine the contribution of the current provided to summation or subtracting inputs of an analog signal processing unit. Therefore, what is described may be considered a mixed-signal architecture that acts as a programmable multiplier, the multiplier coefficient being the control bits, and which may also perform addition and subtraction through the analog component. Division may also be accomplished by use of the resistor network.

In example embodiments, the structure of each basic computing element is relatively simple and may be very area and cost efficient. Multiplication may be achieved using only the resistor means and addition and subtraction makes use of the analog component, such as an operational amplifier. Using a mixed-signal architecture offers further advantages in that, for addition and subtraction at least, there are no rail-to-rail switching gates. Further, many signals are ordinarily analog in many systems, e.g. camera sensor pixels, radio signals, speech/audio signals, etc., and signal processing may be done in such mixed-signal domains using one or more basic computing elements described herein.

Basic computing elements described herein may also be used for applications such as neural networks, matrix calculations, Digital Fourier Transform (DFT) Conversions, Fast Fourier Transform (FFT) Conversions, Discrete Cosine Transform (DCT) conversions and in any application where multiplication, accumulation and/or subtraction operations may be needed. The technology described herein developed for ultra-high density R-2R resistor ladder networks can be used also in DACs and successive approximation ratio (SAR) ADCs so that the area efficiency in such converters may be very high. Advantages of the example embodiments described herein may include improved memory speed, endurance, reliability, and write energy, even over certain emerging memory technologies.

The basic computing element described herein has a structure that is very area and cost efficient. It may provide 10-100 times higher density and much lower cost than current implementations due to, for example, the vertically-formed resistor network implementation that is used as multiplier. Example embodiments also use ultra-low power (10-100 times improvement compared to current CMOS digital implementations) because the multiplier is only a resistor and summing/addition may be performed in the analog domain wherein there are no rail to rail switching gates. Very high implementation density allows parallel computation architectures that can provide high performance.

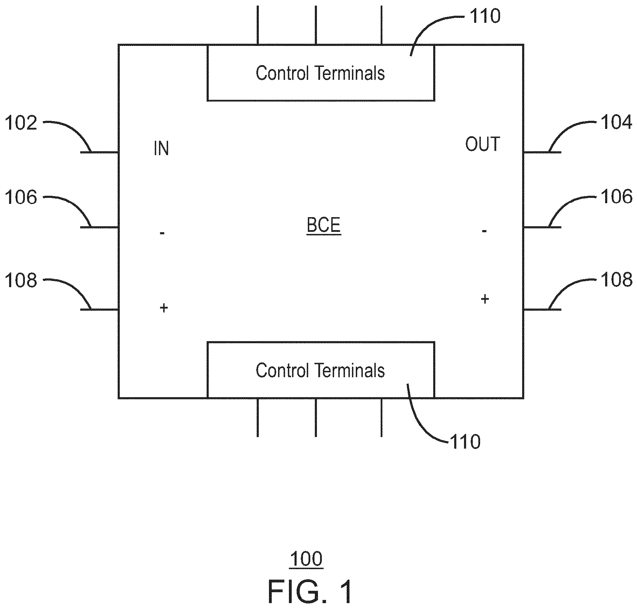

Fig. 1 is a block diagram of a basic computing element 100 in accordance with embodiments. The basic computing element 100 is an apparatus that includes several terminals, including a voltage input (IN) terminal 102, a voltage output (OUT) terminal 104, subtraction bus terminals 106, summation bus terminals 108, and control bit terminals 110. The voltage input terminal 102 may be coupled to a voltage source, which maintains a fixed Direct Current (DC) voltage. In some cases, the voltage input terminal 102 may be coupled to the voltage output terminal of another basic computing element 100. The basic computing element is configured so that the voltage level at the voltage output terminal 104 is a fraction of the voltage level at the voltage input terminal 102. In some embodiments, the voltage level at the voltage output terminal 104 is half of the voltage level at the voltage input terminal 102.

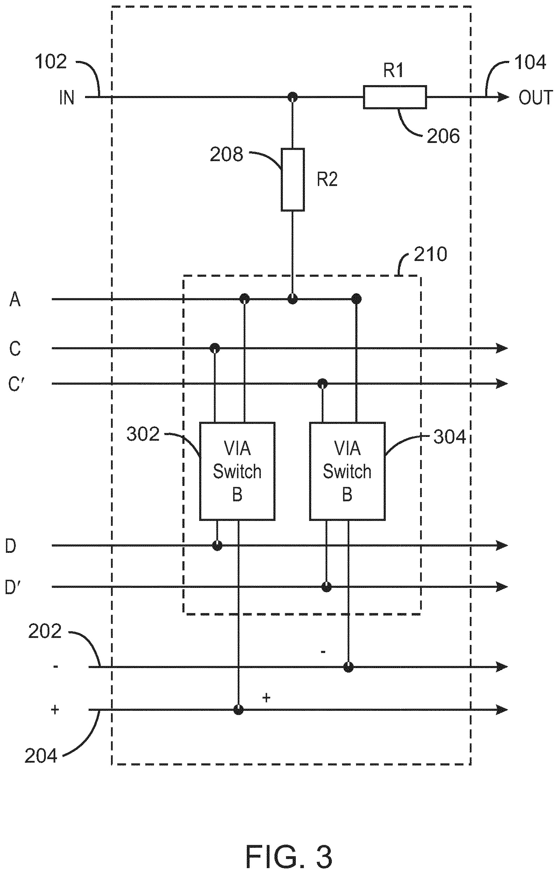

The basic computing element 100 also includes a memory switch (not shown) that routes current received at the voltage input terminal 102 to either the subtraction bus terminals 106 or the summation bus terminals 108. The memory switch is a non-volatile memory element, and the state of the memory element is determined by the control bits received at the control bit terminals 110. Although six control bit terminals 110 are shown, there may be any number of control bit terminals 110 depending on the type of memory switch employed. Various examples of different types of memory switches are described below in relation to Figs. 3, 4, 8, and 9.

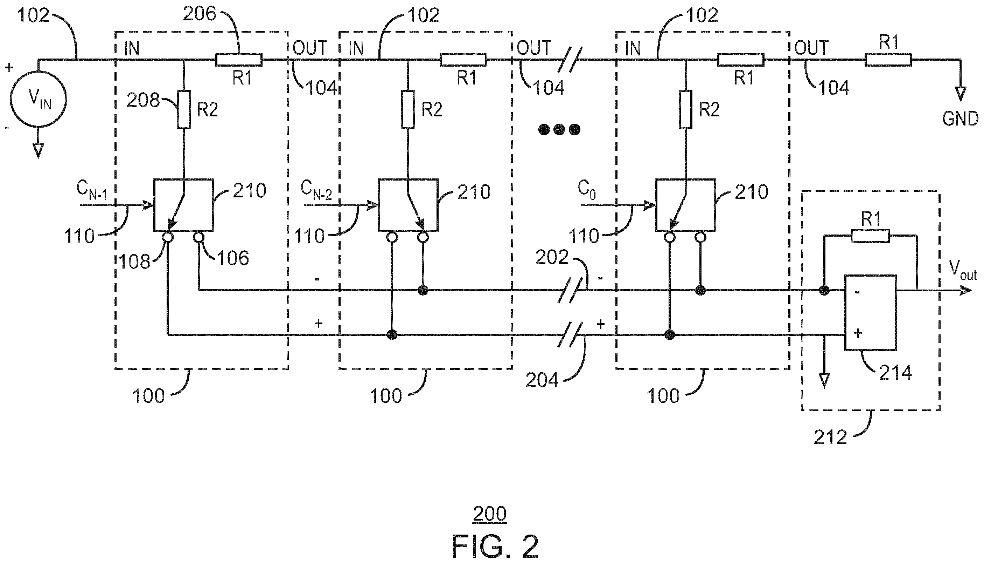

The basic computing element 100 may be arranged with other basic computing elements 100 to from an integrated circuit capable of computational operations. A more detailed description of the basic computing element 100 is shown in Fig. 2 in relation to a resistor ladder network (also referred to herein as an R-2R network).

Fig. 2 is a resistance ladder network that includes a set of basic computing elements, in accordance with embodiments. The resistance ladder network 200 is an apparatus that includes a plurality of basic computing elements 100 connected in series. Although three basic computing elements are shown, the resistance ladder network 200 can include any suitable number of basic computing elements 100 depending on the desired number of voltage output levels to be represented.

As shown in Fig. 2, the voltage output terminal 106 of each basic computing element 100 is coupled to the voltage input terminal 102 of the next basic computing element 100 in the series. The voltage input terminal 102 of the first basic computing element 100 in the series is coupled to a voltage source, $V_{in}$, and the voltage output terminal 106 of the last basic computing element 100 in the series is coupled to ground. Additionally, the subtraction bus terminals 106 are coupled to a subtraction bus 202, and the summation bus terminals 108 are coupled to a summation bus 204. The subtraction bus 202 and the summation bus 204 are coupled to a signal processing unit 212, which includes an operation amplifier 214. The summation bus 204 and the positive input of the operation amplifier 214 are both coupled to ground, and the subtraction bus 202 is coupled to the negative input of the operation amplifier 214.

Each basic computing element 100 may include a first resistor (R1) 206 and a second resistor (R2) 208 arranged as a current divider such that current received at the voltage input terminal 102 is divided through the first resistor 206 and the second resistor 208. The second resistor 208 may have a resistance that is an integer multiple of that of the first resistor 206. In some embodiments, the second resistor 208 is approximately double the first resistor 206 so that the voltage level at the voltage output terminal 106 will be approximately half the voltage level at the voltage input terminal 102. In this configuration, the first basic computing element 100 in the series will have two times the effect on the output of the ladder network 200 compared to the second basic computing element 100, the second basic computing element 100 will have two times the effect on the output of the ladder network 200 compared to the third basic computing element 100, and so on.

The basic computing element 100 also includes a memory switch 210, which determines whether current passing through the second resistor 208 is routed to the summation bus 204 or the subtraction bus 202. The state of the memory switch 210 may be set via the control bit terminals 110. As stated above, the control bit terminals 110 can include any suitable number of control bits depending on the type of memory switch 210. The control bits are shown in Fig. 2 as $C_0$ to $C_{N-1}$, where $C_{N-1}$ can be considered the most significant bit of a binary number and $C_0$ can be considered the least significant bit of the binary number. In this way, the N-bit binary number represented by the control bits $C_{N-1}$ to $C_0$ can be converted to an analog voltage, $V_{out}$, at the output of the ladder network 200. It may therefore be referred to also as an N-bit multiplying digital-to-analog converter (DAC). With the configuration described above, the output, $V_{out}$, will be determined according to the following formula:

$$Vout = -Vin \cdot \sum_{i=0}^{N-1} \left( C_i \cdot 2^{i-N} \right)$$

The ladder network 200 shown in FIG. 2 can be connected in series or in parallel to other basic computing elements 100 to provide additional coefficients for use in computing, such as multiplication, division, addition, and subtraction and any further computational processes that make use of these basic computation types. In some embodiments, a matrix of basic computing elements 100 arranged as parallel ladder networks 200 can be used to implement a vector matrix multiplier application. The vector matrix multiplier application may have a variety of uses, including signal processing applications such as beamforming electromagnetic waves transmitted or received by an antenna array, for example.

In some example embodiments, the ladder network 200 may be used to implement a neural network for a machine learning application. For example, the neural network can include a grid of connected ladder networks 200, such that each resistor ladder network 200 is programmed to represent a weight representing the strength of the connection between two nodes of the neural network. A network of such basic computing elements, configured as multiple ladder networks 200, can be used to create neural networks that grow organically from learning by forming connections between neurons and tuning the strength of the connection while learning more.

The basic computing element 100 introduced herein may be for a wide variety of other computing applications, such as media processing applications configured to compressing or decompress media such as video and/or audio media. In media processing applications, the basic computing element 100 may be used to implement Digital Fourier Transform (DFT) Conversions, Fast Fourier Transform (FFT) Conversions, Discrete Cosine Transform (DCT) conversions, digital-to analog converters or successive approximation ratio (SAR) analog-to-digital converters. DCT is a basic function in image and video processing, and example embodiments therefore offer potential usage in real-time image processing systems, as well as in communications and speech processing systems.

Fig. 3 is an example of a basic computing element that uses a via switch, in accordance with embodiments. As shown in Fig. 3, the memory switch 210 of the basic computing element 100 includes two via switches 302 and 304, a first via switch 302 that couples the second resistor (R2) 208 to the summation bus 204, and second via switch 304 that couples the second resistor (R2) 208 to the subtraction bus 202. The via switches 302 304 are set or reset using the control terminals 110, referred to in this embodiment as A, C, D, C', and D'. Control terminals C and D are used for controlling the first via switch 302 and control terminals C' and D' are used for controlling the second via switch 304. The control lines associated with the control terminals C, D, C' and D' may be routed to several basic computing elements 100, forming a cross-bar switch mechanism for a matrix of basic computing elements 100. The control line associated with control terminal A may be dedicated to a specific one of the basic computing elements 100 and can be used to select the particular basic computing element 100 to be set or reset according to the C, D, C', and D' control lines.

To set or reset the basic computing element, one of the via switches 302 or 304 can be turned on (made conductive) to couple the second resistor 208 to either the summation bus 204 or the subtraction bus 202. For example, to create a summation output, the first via switch 302 is turned on and the second via switch 304 is turned off. In some embodiments, both via switches 302 and 304 can be turned off at the same time so that current doesn't pass to either of the busses 202 204. Once the via switch is set, the via switch maintains its state even after the signals provided through the control lines are discontinued.

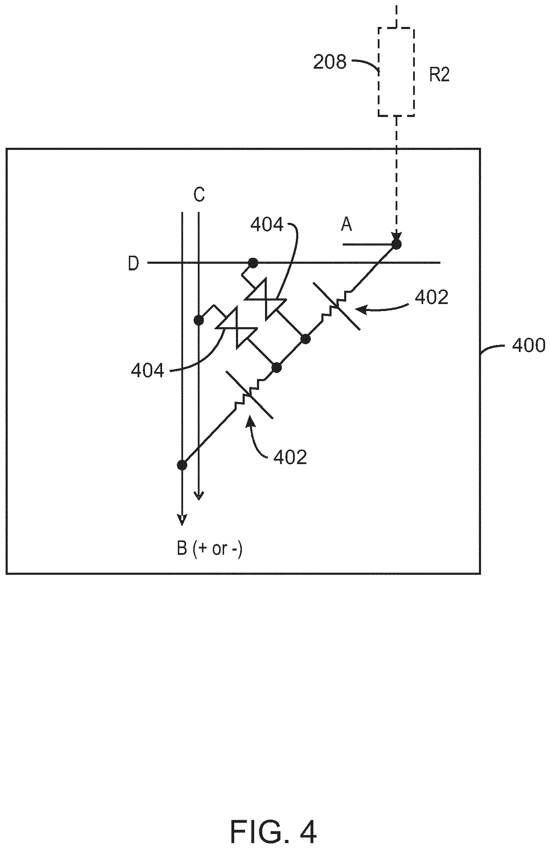

Fig. 4 is a circuit diagram of an example via switch in accordance with embodiments. By comparison with Fig. 3, the via switch 400 may be may represent the via switch 302 or 304, depending on whether the via switch 400 is coupled to the summation bus 204 or the subtraction bus 202. The example via switch of Fig. 4 includes two atom switches 402 and two varistors 404. The atom switch 400 may be any suitable type of atom switch, such as a copper atom switch or others. A typical atom switch, includes two electrodes separated by a polymer electrolyte. Application of a voltage to the electrodes of a specific polarity causes a bridge of conductive metal ions to be formed, causing the atom switch to become conductive, i.e., turned on. Application of a voltage with the opposite polarity eliminates the bridge and causes the switch to be non-conductive, i.e., turned off.

The via switch 400 shown in Fig. 4 is a complimentary atom switch, meaning that is has two atom switches 402 are connected in series with opposite direction, i.e., opposite polarity. In Fig. 4, the B terminal represents the summation bus terminal 108 or the subtraction bus terminal 106, depending on which terminal the via switch is coupled to. To turn the via switch on, a positive voltage is applied to the A terminal and the B terminal while the C terminal and the D terminal are coupled to ground. To turn the via switch off, a positive voltage is applied to the C terminal and the D terminal while the A terminal and the B terminal are coupled to ground.

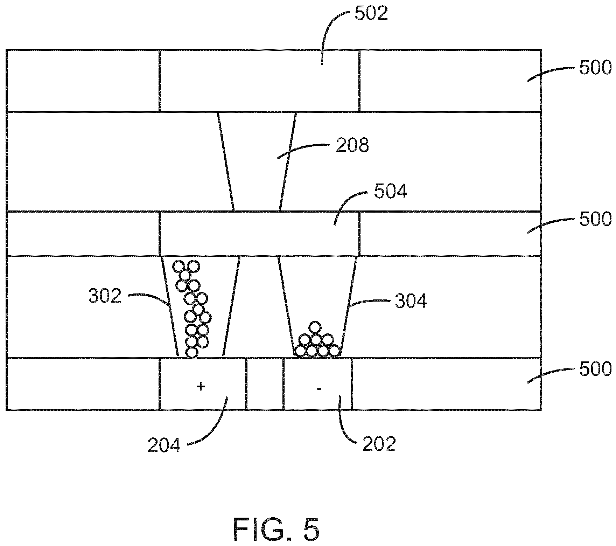

Fig. 5 is a cross-sectional view of part of an integrated circuit that includes a memory switch. The configuration shown in Fig. 5 includes metal layers 500 with conductive traces. The conductive trace 502 is coupled to the second resistor 208 (R2), the conductive trace 504 couples the second resistor 208 to the memory switch, which includes two via switches 302 and 304. The via switches 302 and 304 are coupled to the summation bus 204 and the subtraction bus 202, respectively. Depending on the particular type of via switch used, the configuration can also include one or more control terminals (not shown). However, in some implementations, the via switches 302 304 can be controlled through the conductive trace 504 and the summation or subtraction busses 204 202 with no additional control terminals.

From Fig. 5, it will be seen that this configuration provides a very dense implementation, including a high resistance via contact stacked over and two via switches. No additional transistors or routing elements are required to implement both the routing function and the memory functions of the basic computing element. This provided not only a small volume but also low power consumption.

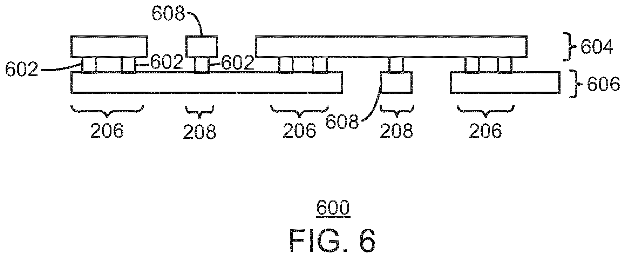

Fig. 6 is a cross sectional view of two layers of an IC implementing a resistor ladder 600. With reference to Fig. 2, the resistor ladder 600 may be used to form the first and second resistors 206 and 208 (R1 and R2) as well as the connections between the first resistors 206 (R1) of a series of basic computing elements 100. The resistor ladder 600 includes a layer of high-resistance contacts 602 sandwiched between first conductive layer 604 and a second conductive layer 606. The first conductive layer 604 and a second conductive layer 606 may be metal layers, for example. Each high-resistance contact 602 may be formed in a same processing step to have substantially the same resistance value.

As shown in Fig. 6, two of the high-resistance contacts 602 are disposed in parallel to implement the first resistor 206 (R1) and a single one of the high-resistance contact 602 is used to implement the second resistor 208 (R2), which will exhibit two times the resistance as the first resistor 206. With reference to Fig. 5, the contacts indicated by reference numeral 608 can be conductively coupled to the conductive trace 504, which couples the second resistor 208 to the via switches 304 or other type of memory switch. The conductive layers 604 and 606 provide the conductive path between the first resistors 206 connecting the voltage input terminal 102 to the voltage output terminal 106 of the next basic computing element 100 in the series.

The resistive contacts 602 may be high-resistance contacts. By "high-resistance" is meant that the resistive contacts have a resistance value that is higher, e.g. much higher, than the on-resistance of switching transistors. For example, in very low power applications, the resistance value may be in the order of Mega ohms, whereas in high speed applications, the resistance value may be in the order of tens of kilo ohms. Typical values may be substantially 100 Kilo ohms and above.

Each resistive contact 602 may be formed by atomic layer deposition (ALD) to provide the one or more high-resistance contacts between the metal layers. ALD is a thin-film deposition technique based on the use of a chemical vapour deposition. In basic terms, a film is grown on a substrate by exposing the substrate to so-called precursor gases in a sequential way that enables accurate control of the film growth and structure. Forming a resistive network using ALD enables at least part of a basic computing element to be formed in a very area and cost-efficient way, because the resistive contacts can be packed in a very dense way and the resistance values determined, for example, based on the cross-sectional area and height of the resistive contacts, assuming the resistors are grown in a vertical way between the metal layers in the manner of three-dimensional structures such as nanostructures. the resistive contacts may be of any suitable material, for example, ultra-thin $Al_2O_{3-y}$ layers on $TiO_{2-x}$ grown using an ALD processes. The surface area of one resistive contact 602 may be only in the order of a hundred square nanometers or thereabouts

The high-resistance contacts may have substantially the same resistance value, the first resistance element comprising two or more high-resistance contacts connected in parallel to provide the same resistance as one high-resistance contact forming the second resistor unit. By providing all contacts with the same resistance value makes fabrication straightforward, enabling good matching between different R and 2R resistor contacts to be achieved. However, other embodiments are also possible. For example, the length of the second resistor 208 may be twice that of the first resistor 206 so that the second resistor has twice the resistance value of the first resistor. Resistor length could be controlled with the number of deposition rounds, i.e. number of layers.

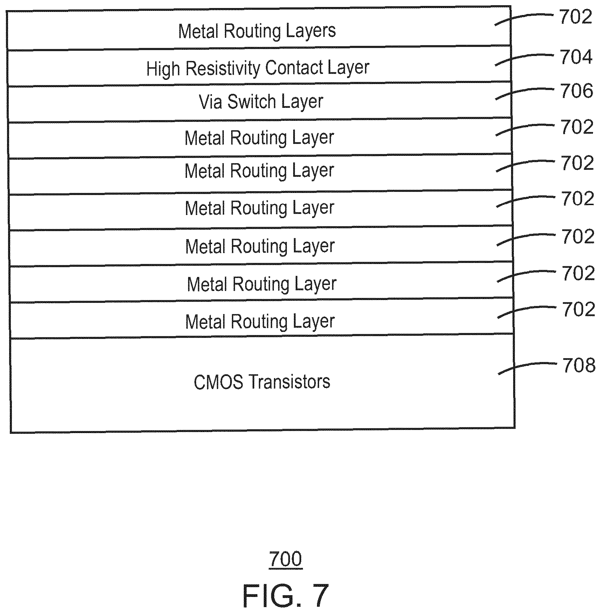

Fig. 7 is a cross-sectional view of a three-dimensional IC implementation 700 according to example embodiments. As shown in Fig. 7, the IC implementation involves fabrication using multiple layers, including a plurality of metal layers routing 702, at least one high-resistivity contact layer 704. The one or more high-resistivity contact layers 704 may be provided by one or more vias. Such a layer or layers may be grown through ALD to achieve high uniformity and controllability. There may be provided more than one high-resistivity layer but usually this may be not needed because the area occupied by the resistors is smaller than the active devices in silicon. In fixed networks, several layers could be used to increase the area efficiency e.g. multiple fixed R-2R layers on top of one another. In fixed networks there is no switch and memory elements saving area and processing cost. Fixed network could be made also programmable with a mask, electron beam or laser. This kind of embodiment could be used for an example in neural network applications with transfer learning. In transfer learning most of the layer could be fixed and only last layers could be programmable for similar type of applications. Fixed value network would save power consumption (no leakage) and silicon cost (processing cost, silicon area).

The IC implementation also includes a least one layer of memory switches, such as via switches 706, although other types of memory switches are also possible. This enables programming the coefficients of a set of basic computing elements (e.g., a ladder network) and their value retained when powered off. The IC implementation also includes a CMOS layer 708, which can include digital memory, transistors such as Metal Oxide Semiconductor (MOS) transistors, Complementary Metal Oxide Semiconductor (CMOS) transistors, gates, switches, amplifiers, voltage sources, and others. The CMOS layer 708 includes the circuitry used for programming the via switches and receiving output signals from the configuration of basic computing elements 100. The CMOS layer 708 can serve as an interface between the analog in-memory computing domain and a more traditional digital processing system. A neural network implementation requiring adaptiveness could utilize this kind of structure. One example could be a pre-trained natural language system, where the neural network is trained for a certain language, e.g. French, but the neural network could adapt to the speaker's speech whilst it is used. This could be used in applications to improve user recognition and even security, for example.

As explained above, the memory switches 210 (Fig. 2) may be any suitable type of memory switch, including via switches as described above. Additional basic computing elements 100 with different types of memory switches 210 are described below.

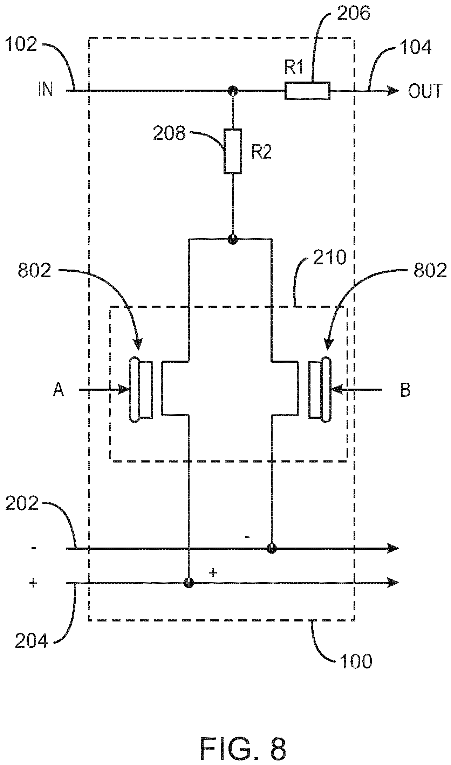

Fig. 8 is a basic computing element with Field Effect Transistors (FETs). The basic computing element 100 of Fig. 8 includes the same features described above in relation to Fig. 2, except that the memory switch 210 is implemented using non-volatile FETs . The FETs 802 in Fig. 8 may be any suitable FET that is able to maintain its state after it is set and the gate signal is subsequently discontinued. In other words, the FETs 802 are non-volatile and store the on/off state. Examples of such FETs include floating gate FETs and Ferro FETs.

A FET is a transistor that is turned on by applying a voltage to the gate, which creates a conductive path between the source and drain. In a floating gate transistor, the gate is electrically isolated and surrounded by highly resistive material. A number of secondary gates are deposited above the floating gate and capacitively connected to the floating gate. Due to the electrical isolation of the floating gate, the charge contained in the floating gate remains unchanged for long periods of time.

A Ferro FET (FeFET) is similar to a MOSFET, except that a layer of Iron (FE) oxide is deposited in the gate-stack. The iron oxide layer creates a capacitance that leads to a hysteresis effect, which causes the FeFET to maintain its state. A memory switch implemented using FeFETs can have fast access, low leakage, and high density.

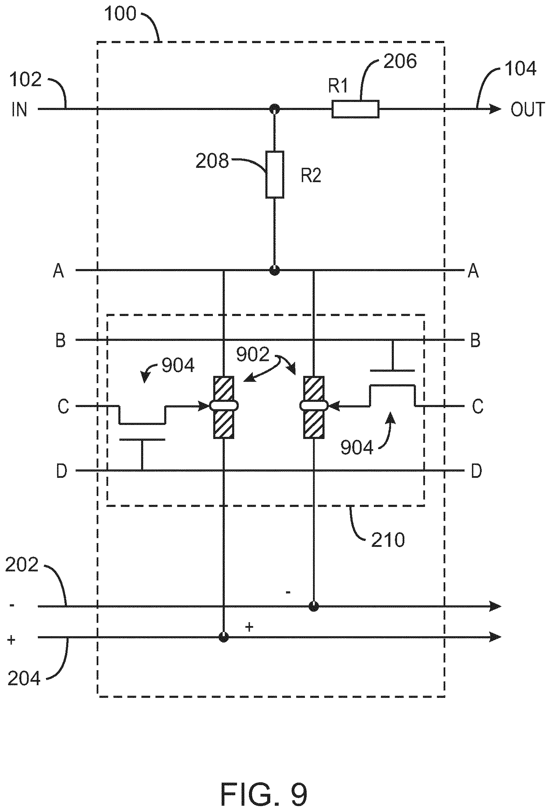

Fig. 9 is a basic computing element with an atom switch. The basic computing element 100 of Fig. 9 includes the same features described above in relation to Fig. 2, except that the memory switch 210 is implemented using a pair of atom switches. As described above, an atom switch is a type switch wherein application of a voltage to the electrodes of a specific polarity causes a bridge of conductive metal ions to be formed, causing the atom switch to become conductive, and application of a voltage with the opposite polarity eliminates the bridge and causes the switch to be non-conductive, i.e., turned off. In this implementation, the memory switch 210 includes two complimentary atom switches 902. Each complimentary atom switch 902 includes back-to-back atom switches disposed in series and sharing a middle electrode. Each atom switch 902 is set or reset by applying a voltage to the middle electrode using a transistor such as a FET 904.

In this example implementation, the B and D control lines select the atom switch to be programmed, and the C control line provides the driving voltage needed for programming. Each R2 leg will require separate access to control line A so that net A is not short circuited between the legs. To turn on a particular atom switch, the A and summation or subtraction bus may be held to ground while a positive voltage is applied to the C terminals. The B and D terminals then determine which FET is turned on and consequently which atom switch is turned on. To turn off a particular atom switch, a positive voltage may be applied to the A and summation or subtraction bus while the C terminal are held to ground. The B and D terminals then determine which FET is turned off and consequently which atom switch is turned off.

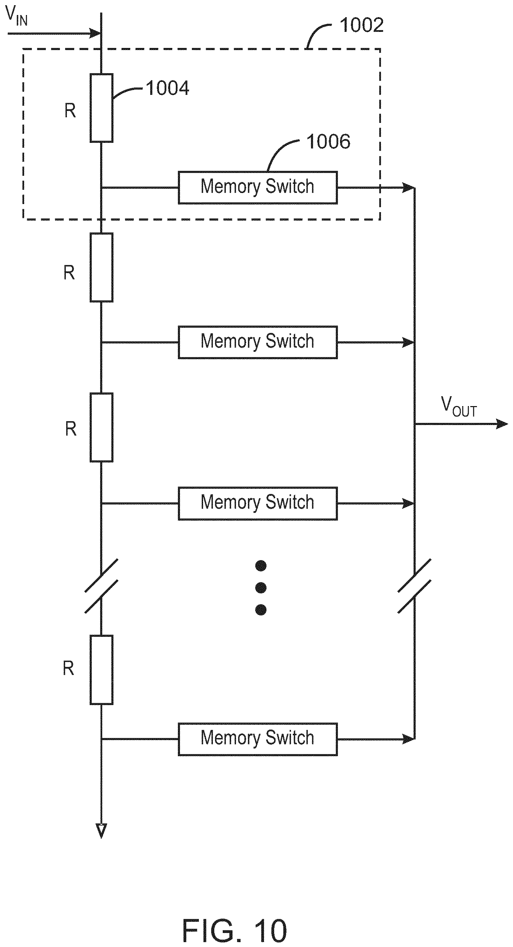

Fig. 10 is a circuit diagram of an integrated circuit with another type of basic computing element 1002 in accordance with embodiments. In this example, the basic computing element 1002 includes a single high resistivity resistor 1004 and a memory switch 1006. The resistors 1004 may be any of the high resistivity contacts described above and may be fabricated as described above. The memory switch 1006 may be a via switch 400 (Fig. 4), a non-volatile FET 802 (Fig. 8), or an atom switch 902 (Fig. 9), for example.

As shown in Fig. 10, a plurality of basic computing elements 1002 is coupled together in series to form a resistor string with high resistivity contacts. At the output of each resistor 1004 is a tap point coupled to a memory switch 1006. The input voltage, $V_{IN}$, can be divided by the resistor string and a suitable output voltage can be selected from one of the tap points by turning on the memory switch 1006 to generate the desired output voltage, $V_{OUT}$. This configuration can be used in resistor string DACs and may be suitable for slower speed, ultra-low power applications. The integrated circuit of Fig. 10 may have any suitable number of basic computing elements 1002 depending on the desired number of voltage output levels to be represented.

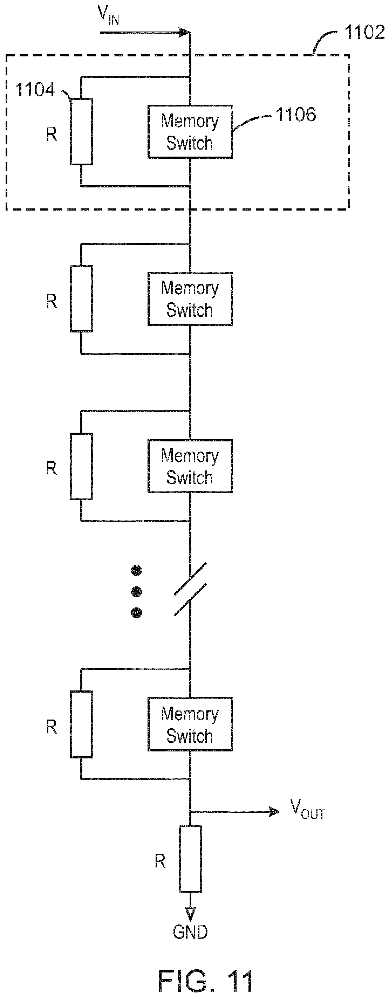

Fig. 11 is a circuit diagram of another integrated circuit with another type of basic computing element 1102 in accordance with embodiments. In this example, the basic computing element 1102 includes a single high resistivity resistor 1104 in parallel with a memory switch 1106. The resistors 1104 may be any of the high resistivity contacts described above and may be fabricated as described above. The memory switch 1106 may be a via switch 400 (Fig. 4), a non-volatile FET 802 (Fig. 8), or an atom switch 902 (Fig. 9), for example.

As shown in Fig. 11, a plurality of basic computing elements 1102 is coupled together in series to form a resistor string with high resistivity contacts. Each resistor 1104 of the resistor string has a parallel memory switch 1106 that can shunt (i.e., short circuit) the resistor 1104 so that the total resistance of the resistor string depends on the number of switches that are turned on (conductive). In the example shown in Fig. 11, the resistor string is configured as one branch of a voltage divider circuit. With this configuration, the output voltage, $V_{OUT}$, will be nearly equal to the input voltage, $V_{IN}$, if all of the resistors are shunted (i.e., all of the memory switches are conductive), and the output voltage will be gradually reduced as more memory switches are switched off and the resistance of the resistor string increases. The integrated circuit of Fig. 11 may have any suitable number of basic computing elements 1102 depending on the desired number of output levels to be represented.

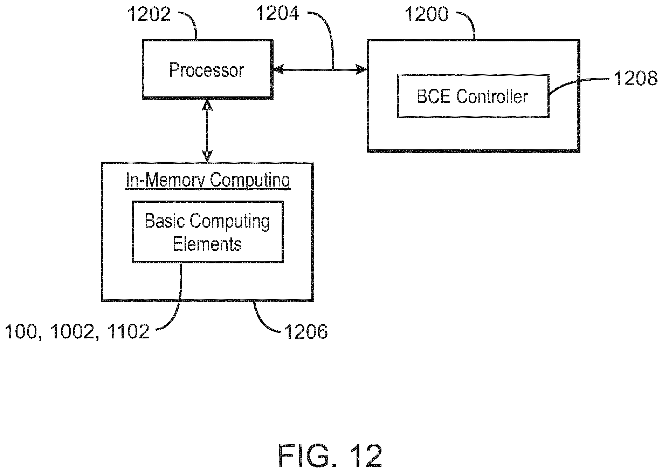

Fig. 12 is a block diagram showing a medium 1200 that contains logic for controlling an in-memory computing device. The medium 1200 may be a computer-readable medium, including a non-transitory medium that stores code that can be accessed by a processor 1202 over a computer bus 1204. For example, the computer-readable medium 1200 can be volatile or non-volatile data storage device. The medium 1200 can also be a logic unit, such as an Application Specific Integrated Circuit (ASIC), a Field Programmable Gate Array (FPGA), or an arrangement of logic gates implemented in one or more integrated circuits, for example.

The processor 1202 is also connected to an in-memory computing device 1206 that includes a plurality of basic computing elements. The basic computing elements may be any of the basic computing elements described herein, including basic computing elements 100, the basic computing elements 1002 shown in Fig. 10, or the basic computing elements 1102 shown in Fig. 11. The basic computing elements may be configured as a neural network, digital to analog processor, analog to digital processor, and others. In some examples, the basic computing elements are arranged as one or more resistor ladders or one or more resistor strings as shown in Figs. 10 or 11.

The medium 1200 may include modules configured to perform at least some of the techniques described herein when executed by the processor 1202. For example, a BCE controller 1208 can include instructions for programming the basic computing elements. Programming the basic computing elements 100 can include setting the non-volatile memory switches of several basic computing elements 100 to cause each basic computing element 100 to route current to a summation bus or a subtraction bus. The programming of the basic computing elements of a resistor network can convert a digital numerical value to a corresponding analog signal, which may represent a connection weight between nodes of a neural network, for example. Programming the basic computing elements 1002 can include setting the memory switches of several basic computing elements 1002 to cause a selected tap point to be activated to generate a desired output voltage. Programming the basic computing elements 1102 can include setting the memory switches of several basic computing elements 1102 to change the total resistance of the resistor string to produce a desired output voltage.

In some embodiments, the BCE controller 1208 may be a module of computer code configured to direct the operations of the processor 1202. A computing system can be built using the basic computing elements described herein so that control of the computing happens with digital control but mathematical operations (multiplications, divisions, subtractions and additions) happen in analog domain using Ohm's and Kirchoff laws. This enables fast and easy control by writing the basic computing element memories and fast, low power and full analog precision calculations (not quantized to low number of bits) so this analog digital computer would enable easy to program, very high performance and very low power computing.

The block diagram of Fig. 12 is not intended to indicate that the medium 1200 is to include all of the components shown in Fig. 12. Further, the medium 1200 may include any number of additional components not shown in Fig. 12, depending on the details of the specific implementation.

It is to be understood that what is described above is what is presently considered the preferred embodiments. However, it should be noted that the description of the preferred embodiments is given by way of example only and that various modifications may be made without departing from the scope as defined by the appended claims.

## Claims

1. An apparatus comprising:

   a resistive network comprising a plurality of basic computing elements (100) coupled in series, each basic computing element comprising a first resistor (206) having a first resistance value and a second resistor (208) having a second resistance value, wherein the first resistor couples an input voltage to an output voltage to be provided to a next basic computing element of the plurality of basic computing elements, wherein the first and second resistors are configured as a current or voltage divider, wherein the first resistor and the second resistor comprise one or more high-resistance contacts formed by atomic layer deposition (ALD) of material sandwiched between conductive layers, and wherein the second resistor of the resistive network is coupled to an input of a memory switch (210) that routes current received through the second resistor to either a summation bus or a subtraction bus, wherein the memory switch (210) comprises a first via switch (302) coupled to the summation bus and a second via switch (304) coupled to the subtraction bus; and
   a signal processing unit (212) coupled to the summation bus and the subtraction bus.

2. The apparatus of claim 1, wherein the high-resistance contacts have substantially a same resistance value, the second resistor comprises a single one of the high-resistance contacts, and the first resistor comprises two or more of the high-resistance contacts connected in parallel.

3. The apparatus of any one of claims 1 to 2, wherein the second resistance value is substantially twice that of the first resistance value.

4. The apparatus of any one of claims 1 to 3, wherein the memory switch comprises a first atom switch coupled to the summation bus and a second atom switch coupled to the subtraction bus.

5. A computing element (100), comprising:

   a first resistor (206) having a first resistance value and coupled in series between an input voltage and an output voltage;
   a second resistor (208) having a second resistance value and coupled at an input of the first resistor to form a voltage or current divider; and a memory switch (210) coupled at the output of the second resistor and configurable to route current received from the input through the second resistor to either a summation bus or a subtraction bus,

wherein the first resistor and the second resistor comprise one or more high-resistance contacts formed by atomic layer deposition (ALD) of material sandwiched between conductive layers and wherein the memory switch (210) comprises a first via switch (302) coupled to the summation bus and a second via switch (304) coupled to the subtraction bus.

6. The computing element of claim 5, wherein the computing element is used in an application comprising one or more of:

a vector matrix multiplier application configured to beamform electromagnetic waves;
a media processing application configured to compress media, wherein the media comprises one or more of video or audio; and
a machine learning application.

**Patentansprüche**

1. Vorrichtung, die Folgendes umfasst:

ein Widerstandsnetzwerk, das eine Vielzahl von grundlegenden Datenverarbeitungselementen (100) umfasst, die in Reihe gekoppelt sind, wobei jedes grundlegende Datenverarbeitungselement einen ersten Widerstand (206), der einen ersten Widerstandswert aufweist, und einen zweiten Widerstand (208), der einen zweiten Widerstandswert aufweist, umfasst, wobei der erste Widerstand eine Eingangsspannung an eine Ausgangsspannung koppelt, die einem nächsten grundlegenden Datenverarbeitungselement der Vielzahl von grundlegenden Datenverarbeitungselementen bereitzustellen ist, wobei der erste und der zweite Widerstand als ein Strom- oder Spannungsteiler ausgelegt sind, wobei der erste Widerstand und der zweite Widerstand einen oder mehrere Hochwiderstandskontakte umfassen, die durch Atomlagenabscheidung (ALD) von Material gebildet sind, das zwischen leitfähigen Lagen eingeschlossen ist, und wobei der zweite Widerstand des Widerstandsnetzwerks an einen Eingang eines Speicherschalters (210) gekoppelt ist, der einen Strom, der über den zweiten Widerstand empfangen wird, entweder zu einem Summierungsbus oder einem Subtraktionsbus leitet, wobei der Speicherschalter (210) einen ersten Durchkontaktierungsschalter (302), der an den Summierungsbus gekoppelt ist, und einen zweiten Durchkontaktierungsschalter (304), der an den Subtraktionsbus gekoppelt ist, umfasst; und
eine Signalverarbeitungseinheit (212), die an den Summierungsbus und den Subtraktionsbus gekoppelt ist.

2. Vorrichtung nach Anspruch 1, wobei die Hochwiderstandskontakte im Wesentlichen einen selben Widerstandswert aufweisen, der zweite Widerstand einen einzelnen der Hochwiderstandskontakte umfasst und der erste Widerstand zwei oder mehr der Hochwiderstandskontakte umfasst, die parallel verbunden sind.

3. Vorrichtung nach einem der Ansprüche 1 bis 2, wobei der zweite Widerstandswert im Wesentlichen doppelt so groß ist wie der erste Widerstandswert.

4. Vorrichtung nach einem der Ansprüche 1 bis 3, wobei der Speicherschalter einen ersten Atomschalter, der an den Summierungsbus gekoppelt ist, und einen zweiten Atomschalter, der an den Subtraktionsbus gekoppelt ist, umfasst.

5. Datenverarbeitungselement (100), das Folgendes umfasst:

einen ersten Widerstand (206), der einen ersten Widerstandswert aufweist und in Reihe zwischen einer Eingangsspannung und einer Ausgangsspannung gekoppelt ist;
einen zweiten Widerstand (208), der einen zweiten Widerstandswert aufweist und an einen Eingang des ersten Widerstands gekoppelt ist, um einen Spannungs- oder Stromteiler zu bilden; und
einen Speicherschalter (210) der an den Ausgang des zweiten Widerstands gekoppelt und auslegbar ist, einen Strom, der vom Eingang des zweiten Widerstands empfangen wird, über den zweiten Widerstand entweder zu einem Summierungsbus oder einem Subtraktionsbus zu leiten,
wobei der erste Widerstand und der zweite Widerstand einen oder mehrere Hochwiderstandskontakte umfassen, die durch Atomlagenabscheidung (ALD) von Material gebildet sind, das zwischen leitfähigen Lagen eingeschlossen ist, und wobei der Speicherschalter (210) einen ersten Durchkontaktierungsschalter (302), der an den Summierungsbus gekoppelt ist, und einen zweiten Durchkontaktierungsschalter (304), der an den Subtraktionsbus gekoppelt ist, umfasst.

**6.** Datenverarbeitungselement nach Anspruch 5, wobei das Datenverarbeitungselement in einer Anwendung verwendet wird, die eines oder mehreres von Folgendem umfasst:

einer Vektormatrixmultiplikatoranwendung, die dazu ausgelegt ist, elektromagnetische Wellen strahlzuformen;
einer Medienverarbeitungsanwendung, die dazu ausgelegt ist, Medien zu komprimieren, wobei die Medien eines oder mehreres von Video oder Audio umfassen; und
einer Maschinenlernanwendung.

**Revendications**

**1.** Appareil comprenant :

un réseau de résistances comprenant une pluralité d'éléments informatiques de base (100) couplés en série, chaque élément informatique de base comprenant une première résistance (206) ayant une première valeur de résistance et une deuxième résistance (208) ayant une deuxième valeur de résistance, dans lequel la première résistance couple une tension d'entrée à une tension de sortie devant être fournie à un élément informatique de base suivant de la pluralité d'éléments informatiques de base, dans lequel les première et deuxième résistances sont configurées comme un diviseur de courant ou de tension, dans lequel la première résistance et la deuxième résistance comprennent un ou plusieurs contacts à haute résistance formés par dépôt de couche atomique (ALD) d'un matériau intercalé entre des couches conductrices, et dans lequel la deuxième résistance du réseau de résistances est couplée à une entrée d'un commutateur de mémoire (210) qui achemine le courant reçu à travers la deuxième résistance soit vers un bus de sommation soit vers un bus de soustraction, dans lequel le commutateur de mémoire (210) comprend un premier commutateur d'interconnexion (302) couplé au bus de sommation et un deuxième commutateur d'interconnexion (304) couplé au bus de soustraction ; et
une unité de traitement de signal (212) couplée au bus de sommation et au bus de soustraction.

**2.** Appareil selon la revendication 1, dans lequel les contacts à haute résistance ont sensiblement une même valeur de résistance, la deuxième résistance comprend un seul des contacts à haute résistance, et la première résistance comprend deux contacts à haute résistance ou plus connectés en parallèle.

**3.** Appareil selon l'une des revendications 1 à 2, dans lequel la deuxième valeur de résistance est égale sensiblement au double de la première valeur de résistance.

**4.** Appareil selon l'une des revendications 1 à 3, dans lequel le commutateur de mémoire comprend un premier commutateur d'atomes couplé au bus de sommation et un deuxième commutateur d'atomes couplé au bus de soustraction.

**5.** Élément informatique (100), comprenant :

une première résistance (206) ayant une première valeur de résistance, et couplée en série entre une tension d'entrée et une tension de sortie ;
une deuxième résistance (208) ayant une deuxième valeur de résistance, et couplée à une entrée de la première résistance pour former un diviseur de tension ou de courant ; et
un commutateur de mémoire (210) couplé à la sortie de la deuxième résistance et configurable pour acheminer le courant reçu de l'entrée à travers la deuxième résistance soit vers un bus de sommation soit vers un bus de soustraction,
dans lequel la première résistance et la deuxième résistance comprennent un ou plusieurs contacts à haute résistance formés par dépôt de couche atomique (ALD) d'un matériau intercalé entre des couches conductrices, et dans lequel le commutateur de mémoire (210) comprend un premier commutateur d'interconnexion (302) couplé au bus de sommation et un deuxième commutateur d'interconnexion (304) couplé au bus de soustraction.

**6.** Élément informatique selon la revendication 5, dans lequel l'élément informatique est utilisé dans une application comprenant une ou plusieurs applications parmi :

une application de multiplicateur de matrice vectorielle configurée pour la formation de faisceaux d'ondes électromagnétiques ;
une application de traitement des médias configurée pour compresser des médias, dans lequel les médias comprennent un ou plusieurs parmi une vidéo ou un audio ; et
une application d'apprentissage machine.

100

FIG. 1

FIG. 2
200

FIG. 3

FIG. 4

FIG. 5

600
FIG. 6

| | |
|---|---|
| Metal Routing Layers | 702 |
| High Resistivity Contact Layer | 704 |
| Via Switch Layer | 706 |
| Metal Routing Layer | 702 |
| Metal Routing Layer | 702 |
| Metal Routing Layer | 702 |
| Metal Routing Layer | 702 |
| Metal Routing Layer | 702 |
| Metal Routing Layer | 702 |
| CMOS Transistors | 708 |

<u>700</u>

# FIG. 7

FIG. 8

FIG. 9

FIG. 10

$V_{IN}$

1102

1104

R

Memory
Switch — 1106

R

Memory
Switch

R

Memory
Switch

R

Memory
Switch

$V_{OUT}$

R

GND

# FIG. 11

FIG. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P RAMAKRISHNA**. Design of low power 10GS/s 6-Bit DAC using CMOS technology. *International Journal of Engineering and Technology*, 01 January 2018, 226-229